# FASCICULE DE BREVET EUROPEEN

(11) **EP 0 603 285 B1**
(45) Date de publication et mention de la délivrance du brevet: **03.05.1995**
(21) Numéro de dépôt: 92919647.5
(22) Date de dépôt: 31.08.1992
(51) Int. Cl.: G05F 1/46, G05F 3/24, G11C 5/14, G11C 16/06

(54) **CIRCUIT DE REGULATION DE TENSION DE PROGRAMMATION, POUR MEMOIRES PROGRAMMABLES**
PROGRAMMIERUNGSSPANNUNGSREGELSCHALTUNG FÜR PROGRAMMIERBARE SPEICHER
CIRCUIT FOR CONTROLLING THE PROGRAMMING VOLTAGE OF PROGRAMMABLE MEMORIES

(30) Priorité: 05.09.1991 FR 9111008
(43) Date de publication de la demande: 29.06.1994
(73) Titulaire: GEMPLUS CARD INTERNATIONAL, F-13420 Gémenos (FR)
(72) Inventeur: KOWALSKI, Jacek, F-13530 Trets (FR)
(74) Mandataire: Schmit, Christian Norbert Marie
(86) Numéro de dépôt international: FR9200833
(87) Numéro de publication internationale: WO9305513

(56) Documents cités:
- EP-A- 0 382 929
- PATENT ABSTRACTS OF JAPAN vol. 10, no. 272 (E-437)(2328) 16 September 1986
- PATENT ABSTRACTS OF JAPAN vol. 10, no. 89 (P-444)(2146) 8 April 1986

## Description

L'invention concerne les mémoires électriquement programmables en circuit intégré, connues généralement sous l'appellation "mémoires EEPROM" ou "mémoires EPROM" selon qu'elles sont effaçables électriquement ou non, ou encore "flash EPROM" lorsqu'elles sont effaçables par blocs.

Pour programmer ces mémoires, il est généralement nécessaire de disposer dans le circuit intégré d'une tension dite "tension de programmation", Vpp, qui est nettement supérieure à la tension d'alimentation normale Vcc du circuit. Par exemple, Vcc est couramment égal à 5 volts et Vpp à 15 volts ou plus.

Dans certaines mémoires, la tension de programmation Vpp est fournie par une alimentation extérieure. Mais cela nécessite alors une borne d'alimentation spécifique supplémentaire pour le circuit intégré. Les bornes supplémentaires grèvent le coût des circuits intégrés et on préfère les éviter. Dans certaines applications, de toutes façons le nombre de bornes est imposé (exemple : cartes à puces à 6 ou 8 bornes) et il n'est pas question d'en rajouter une. Dans d'autres applications, il peut même ne pas y avoir de bornes d'alimentation extérieure (exemple : carte à puce sans contact dont l'énergie de fonctionnement est apportée par voie électromagnétique).

C'est pourquoi on a proposé des mémoires intégrées, dans lesquelles la tension de programmation Vpp est produite à l'intérieur même du circuit intégré, à partir de la tension d'alimentation normale Vcc. On utilise pour cela un circuit classiquement appelé pompe de charge ou élévateur de tension qui reçoit Vcc et établit une tension Vpp supérieure à Vcc.

Les circuits élévateurs sont classiques; un étage élévateur de base utilise simplement des interrupteurs, deux capacités, et une horloge à deux phases pour actionner les interrupteurs. Dans un premier temps on charge la première capacité à 5 volts, puis on la décharge dans la deuxième. Puis un cycle recommence premier temps, charge de la première capacité à 5 volts, et deuxième temps, décharge dans la deuxième (cette fois la deuxième est déjà partiellement chargée); la tension aux bornes de la deuxième capacité augmente alors à chaque coup d'horloge. En quelques coups d'horloge à deux phases, on atteint une tension double de Vcc sur la deuxième capacité. Avec deux étages, on multiplie la tension Vcc par 4 en quelques coups d'horloge; etc.

Le niveau de tension de sortie du circuit élévateur, disponible sur une capacité, est maintenu à une valeur fixe par un régulateur. Ce régulateur peut être constitué par une chaîne de transistors qui sont montés en diodes pour établir chacun entre sa source et son drain une tension égale à sa tension de seuil. Selon la technologie mise en oeuvre, la tension de seuil varie et le nombre de transistors en série permet de définir la tension régulée en sortie du régulateur.

Par exemple, avec des transistors ayant une tension de seuil de l'ordre de 1 volt, il faut 16 transistors pour établir une tension régulée Vpp de l'ordre de 16 volts.

Un inconvénient majeur des circuits existants est leur consommation de courant importante, due à la fois à la consommation propre de la pompe de charge et à celle du régulateur. Or on souhaite généralement diminuer cette consommation; d'ailleurs dans certains cas il est absolument indispensable de trouver des solutions qui minimisent la consommation : par exemple dans le cas des circuits intégrés pour cartes à puces "sans contacts".

Un but de l'invention est de proposer un circuit de génération de tension de programmation Vpp qui consomme moins que les circuits de l'art antérieur et qui ait par ailleurs un bon rapport qualité/coût, notamment sur le plan de la fiabilité de fonctionnement, et de la place occupée sur le circuit..

Plus généralement, un but de l'invention est de proposer un nouveau circuit de production d'une tension régulée, que ce soit pour une mémoire programmable ou non.

L'invention est définie par la revendication 1. Le circuit de production d'une tension régulée Vpp comporte une pompe de charge, un circuit de régulation apte à arrêter la pompe de charge lorsque la tension Vpp devient supérieure à un seuil déterminé, des moyens pour interrompre la consommation de courant du circuit de régulation lorsque la tension Vpp devient supérieure à un seuil (qui est de préférence le même que le précédent), et un circuit de contrôle apte à détecter une faible baisse de la tension Vpp au dessous de la valeur fournie par le circuit de régulation, et à réactiver la pompe de charge et la consommation de courant du circuit de régulation lorsque cette baisse dépasse une valeur dV prédéterminée.

Dans l'art antérieur le circuit de régulation (ou régulateur) fonctionne en permanence et consomme du courant en permanence. Ici, le régulateur est mis hors service dès qu'il a détecté que la bonne valeur de tension de programmation est atteinte. Et c'est un circuit de contrôle, consommant très peu de courant, qui examine la stabilité de la tension obtenue; si la tension baisse trop, il remet en service à la fois la pompe de charge et le régulateur.

Le circuit de contrôle n'est pas équivalent à un autre régulateur qui serait semblable au premier. Il peut être construit de manière à consommer très peu de courant car sa fonction n'est pas de vérifier la conformité de la tension à une valeur prédéterminée (par exemple 15 volts), mais de vérifier que la tension obtenue à un moment donné (grâce au régulateur) ne baisse pas de plus d'une valeur dV déterminée (par exemple 0,5 volt).

Le régulateur sera construit de préférence à l'aide d'un diviseur résistif composé de multiples résistances de forte valeur (de l'ordre du mégohm chacune); ces résistances peuvent être réalisées par des transistors à canal P formés dans des caissons de type N respectifs, séparés les uns des autres (cas d'un substrat de type P), ces transistors ayant leur drain et leur grille réunies. La source de chaque transistor est de préférence reliée au caisson correspondant.

Le régulateur comporte aussi un détecteur de niveau de tension (ou comparateur) pour comparer à une référence le niveau de tension sur un point intermédiaire du diviseur résistif; ce détecteur comporte par exemple une entrée reliée à l'une des résistances et il peut avoir une autre entrée recevant un niveau de tension de référence. La sortie de ce détecteur commande la pompe de charge pour pouvoir interrompre son fonctionnement, et elle commande aussi de préférence un transistor d'alimentation en courant du diviseur résistif pour interrompre la circulation de courant dans ce dernier. L'ensemble du diviseur résistif et du transistor d'alimentation en courant est connecté entre la borne du régulateur qui fournit la tension Vpp et une masse.

Le circuit de contrôle comporte de préférence une capacité reliée entre un noeud flottant et une borne du régulateur fournissant la tension Vpp. Le noeud flottant peut être préchargé à une valeur Vprech, et il est connecté à une entrée d'un comparateur recevant par ailleurs sur une autre entrée une tension de référence égale à Vprech-dV. La différence de potentiel dV définit (directement ou indirectement) une valeur de baisse de tension acceptable pour la tension Vpp. Elle est par exemple de quelques dixièmes de volt. La sortie de ce comparateur est connectée de manière à commander la réactivation de la pompe de charge et l'alimentation en courant du diviseur.

Les caractéristiques et avantages de l'invention apparaîtront à la lecture de la description détaillée qui suit et qui est faite en référence aux dessins annexés dans lesquels :
- la figure 1 représente le schéma synoptique d'un circuit de l'art antérieur;
- la figure 2 représente le schéma synoptique d'un circuit selon l'invention;
- la figure 3 représente un schéma détaillé d'un mode de réalisation de l'invention.
- la figure 4 représente un détail du régulateur;
- la figure 5 représente un diagramme temporel des signaux du circuit de la figure 3.

L'invention sera décrite à propos de la production d'une tension de programmation pour une mémoire électriquement programmable, sans que cette application doive être considérée comme limitative.

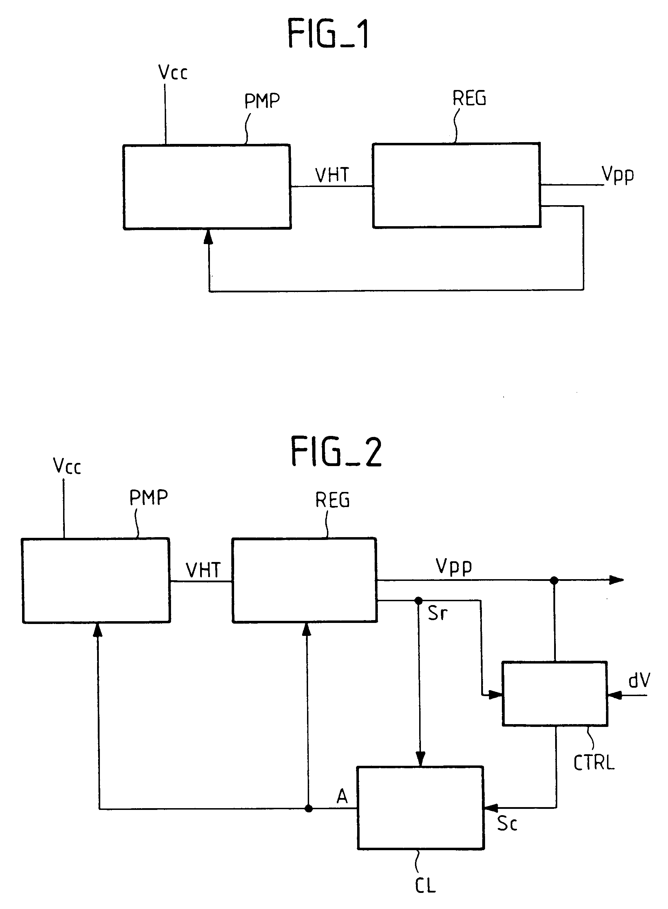

On a rappelé à la figure 1 quelle était la constitution antérieure d'un circuit de génération d'une tension de programmation Vpp pour une mémoire EPROM ou EEPROM, lorsqu'on veut que la tension soit produite à l'intérieur du circuit intégré.

Le circuit intégré est alimenté par une tension Vcc, par exemple 5 volts. Cette tension sert à faire fonctionner un circuit élévateur de tension PMP, souvent appelé pompe de charge compte-tenu de son mode de fonctionnement. Cette pompe de charge PMP produit une tension VHT nettement plus élevée que Vcc, par exemple entre 15 et 20 volts.

La tension VHT, est appliquée à un circuit régulateur REG qui fournit la tension de programmation Vpp à partir de la tension VHT. La tension Vpp peut être égale à la tension VHT. Le circuit de régulation REG a pour fonction principale de comparer la tension Vpp a une valeur de référence, de fournir un signal d'interruption de la pompe de charge lorsque Vpp dépasse un seuil déterminé, et de la remettre en route si Vpp redescend au dessous de ce seuil (avec éventuellement une hystérésis).

Le régulateur utilise le plus souvent un pont diviseur résistif et il consomme du courant.

Le schéma du circuit selon l'invention est représenté sous forme globale à la figure 2. Il y a toujours une pompe de charge ou circuit élévateur de tension PMP, qui a le même rôle que précédemment et qui peut être constituée comme dans la technique antérieure.

La pompe de charge fournit une tension VHT, disponible sur une capacité de sortie de la pompe de charge, qui est encore appliquée à un circuit régulateur de tension REG. Ce dernier fournit la tension désirée Vpp (qui peut être la tension VHT elle-même). Il compare la tension Vpp à une valeur de référence et fournit un signal Sr lorsque la tension Vpp dépasse cette valeur de référence. Ce signal Sr sert à interrompre le fonctionnement de la pompe de charge.

Comparé au régulateur de la figure 1, le régulateur de la figure 2 possède en outre la particularité suivante : il possède une entrée de commande par laquelle on peut interrompre son alimentation en courant. Cette entrée de commande peut recevoir un signal A qui interrompt l'alimentation en courant. Bien entendu, lorsque l'alimentation du régulateur est ainsi interrompue, il ne peut plus exercer sa fonction de régulation ; mais il ne consomme alors plus de courant, ni sur Vcc ni sur Vpp..

Le signal A est émis à partir du signal Sr lorsque la tension Vpp a atteint sa valeur de référence. C'est ce signal qui sert aussi à interrompre le fonctionnement de la pompe de charge.

Le circuit de génération de Vpp comporte de plus un circuit de contrôle CTRL dont la fonction est la suivante : il reçoit la tension Vpp, et il fournit un signal Sc dès que cette tension descend de plus d'une quantité dV au dessous de la valeur initiale qu'elle possède sensiblement au moment où le fonctionnement de la pompe de charge est interrompu par le signal A.

Ce circuit de contrôle ne compare donc pas la tension Vpp à un seuil de référence absolu, mais il part de la valeur initiale Vpp0 de la tension Vpp à un instant donné et il détecte la chute d'une valeur dV pour fournir un signal lorsque Vpp descend au dessous de Vpp0-dV. Vpp0 est de préférence justement la tension de référence atteinte par Vpp lorsque le régulateur émet le signal Sr d'arrêt de la pompe de charge.

Le signal Sc émis par le circuit de contrôle sert à rétablir l'alimentation en courant du circuit de régulation REG et à remettre en route la pompe de charge PMP.

Un circuit logique CL utilise les signaux Sr (issu du régulateur REG) et Sc (issu du circuit de contrôle CTRL) pour fournir le signal A qui commande à la fois l'alimentation en courant du régulateur et le fonctionnement de la pompe de charge. Sr provoque l'établissement du signal A; Sc provoque son interruption.

En d'autres mots, le signal A apparaît sous la commande de Sr pour interrompre l'alimentation en courant du régulateur et interrompre la pompe de charge dès que le régulateur a détecté que Vpp a atteint sa valeur de référence Vpp0. Ce signal A disparaît sous la commande de Sc pour rétablir l'alimentation en courant du régulateur et remettre en route la pompe de charge dès que le circuit de contrôle a détecté le passage de Vpp au dessous de Vpp0-dV.

Ainsi, le régulateur ne consomme du courant que lorsqu'il y a besoin de remonter la tension Vpp par la pompe de charge. Et il y a d'autant moins besoin de la remonter que justement le régulateur ne consomme plus de courant sur le conducteur fournissant Vpp. Il faut savoir en effet que la programmation des cellules de mémoire par Vpp consomme très peu de courant sur Vpp. C'est en fait le régulateur qui consomme et qui fait chuter Vpp dans l'art antérieur, ce qui oblige à réactiver souvent la pompe de charge qui elle aussi consomme beaucoup de courant (sur l'alimentation Vcc).

Cette structure originale trouve donc son intérêt principal lorsque le circuit de contrôle CTRL consomme très peu de courant. On va donner maintenant un exemple de réalisation pratique qui convient bien, notamment de ce point de vue.

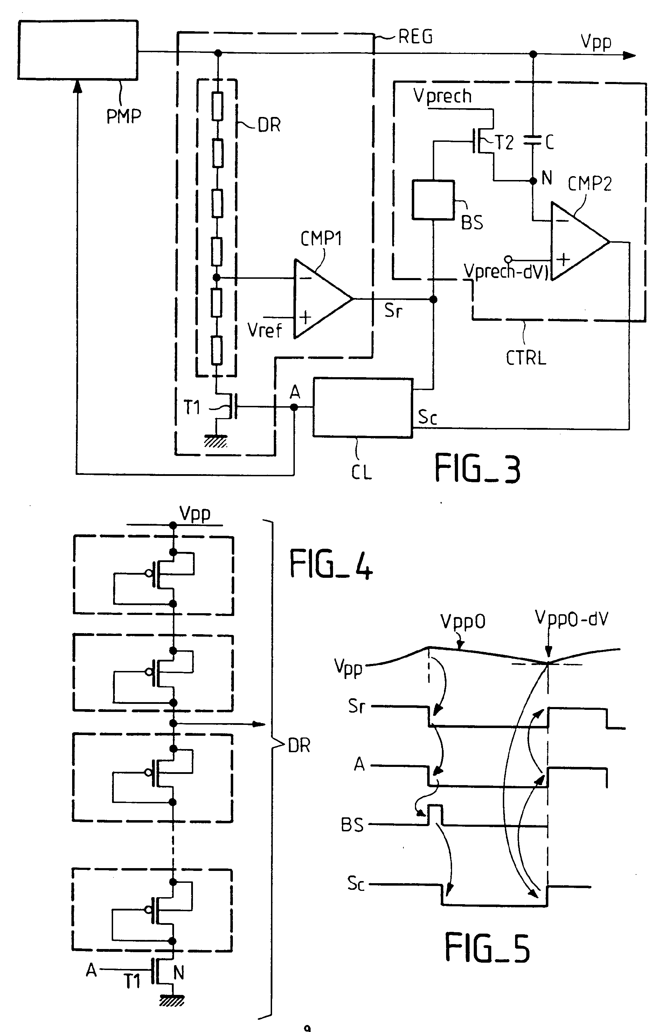

La figure 3 représente un schéma détaillé d'un mode d'exécution préférentiel de l'invention.

La pompe de charge PMP n'a pas été détaillée, du fait qu'elle peut être classique. Elle comporte un oscillateur, des interrupteurs commandés en alternance de phase par l'oscillateur, des capacités et éventuellement des diodes. Son fonctionnement consiste à commuter les capacités alternativement en parallèle puis en série pour faire passer toujours dans le même sens une charge d'une première capacité à une deuxième. La charge s'accumule progressivement sur la deuxième capacité. Le signal A qui sert à interrompre ou mettre en route la pompe de charge agira tout simplement en interrompant ou autorisant le fonctionnement de l'oscillateur.

Le circuit de régulation REG comporte de préférence un pont diviseur résistif DR connecté entre la tension Vpp (ici Vpp est directement la tension VHT issue de la pompe de charge) et la masse; un interrupteur constitué par un transistor T1 est cependant interposé entre le diviseur et la masse. Lorsque cet interrupteur est passant, il peut être considéré comme un court-circuit (résistance très faible devant celle du diviseur résistif); lorsqu'il est bloqué, il interrompt le passage du courant dans le diviseur résistif; celui-ci ne consomme alors plus de courant et ne fonctionne plus. La grille du transistor T1 reçoit le signal A mentionné en référence à la figure 2.

Le régulateur REG comporte également un comparateur CMP1 servant de détecteur de niveau de la tension Vpp. Il a une entrée reliée à un point intermédiaire du diviseur résistif et une autre entrée reliée à une tension de référence Vref. Ce comparateur a pour fonction de fournir un signal Sr lorsque la tension au point intermédiaire du diviseur dépasse une tension Vref; cela correspond alors au fait que la tension Vpp appliquée à l'extrémité du diviseur DR dépasse une valeur de référence Vpp0. Le choix du point intermédiaire du diviseur résistif permet, avec une seule valeur de référence Vref, de pouvoir choisir la valeur de référence Vpp0. Dans un circuit intégré, il suffira de modifier une connexion pour choisir le niveau Vpp0.

Les résistances du pont diviseur DR sont de préférence de valeur très élevée (de l'ordre du mégohm) pour minimiser la consommation de courant lorsque le régulateur fonctionne. Dans une technologie CMOS, les résistances seront de préférence réalisées chacune par un transistor individuel à canal P dont le drain est connecté à la grille. Chaque transistor est placé dans un caisson individuel de type N (différent de celui des autres résistances), ce caisson étant formé dans un substrat P. La source du transistor est de préférence reliée au caisson pour réduire l'effet des variations de potentiel du substrat sur la tension de seuil des transistors.

La valeur de ces résistances n'est pas très précise mais ce qui compte c'est leur rapport qui reste identique dans la mesure où les transistors ont des dimensions identiques ou proportionnelles.

La figure 4 représente le montage du pont diviseur résistif DR. Le transistor T1 qui sert à interrompre l'alimentation en courant est un transistor à canal N. Les caissons séparés sont représentés par des cadres pointillés autour de chaque transistor du diviseur.

Le signal Sr issu du comparateur CMP1 est appliqué au circuit logique CL pour participer à l'élaboration du signal A. De plus, il est appliqué au circuit CTRL pour que celui-ci commence à fonctionner à partir de l'instant où la tension Vpp a atteint la valeur désirée Vpp0.

Plus précisément, le signal Sr est appliqué à une bascule monostable BS faisant partie du circuit de contrôle CTRL; cette bascule établit une courte impulsion à partir du déclenchement du signal Sr. Cette courte impulsion précharge un noeud flottant N à une tension fixe Vprech. Pour cela, par exemple, la sortie de la bascule BS est appliquée à la grille d'un transistor T2 qui est relié entre le noeud flottant N et la tension de précharge Vprech. Le noeud N cesse d'être flottant pendant la courte impulsion de sortie de la bascule BS et il passe au potentiel Vprech. Dès la fin de l'impulsion, il redevient flottant (mis à part les fuites inévitables) du fait qu'il n'est connecté à d'autres éléments de circuit que par des capacités ou par des impédances résistives très élevées.

Le noeud flottant N est en effet connecté d'une part à la tension Vpp par l'intermédiaire d'une capacité C, et d'autre part à une entrée d'un comparateur CMP2 (à très forte impédance d'entrée). L'autre entrée du comparateur est reliée à une tension de référence qui a une valeur Vprech-dV, où dV représente (directement ou éventuellement à un facteur multiplicatif près) la chute de tension maximale acceptable sur Vpp. La sortie du comparateur CMP2 fournit le signal Sc qui contribue à l'élaboration du signal A mentionné en référence à la figure 2.

Le circuit de contrôle fonctionne de la manière suivante : au moment où Vpp atteint la valeur Vpp0, la bascule BS fournit l'impulsion de précharge du noeud flottant. Celui-ci passe à la tension Vprech. La tension aux bornes de la capacité C devient Vpp0-Vprech. Lorsque l'impulsion se termine, la capacité C reste chargée à la tension Vpp0-Vprech. Si maintenant la tension Vpp évolue et baisse par suite d'une consommation de courant utile ou parasite, le noeud flottant va suivre les variations de Vpp. Si Vpp passe au dessous de Vpp0-dV, la tension du noeud flottant passera au dessous de Vprech-dV et le comparateur fournira le signal Sr qui va remettre en route la pompe de charge et le régulateur.

Cette explication ne tient pas compte du fait qu'une capacité parasite relativement élevée peut exister entre le noeud flottant et la masse. Dans ce cas, on a deux solutions : ou bien on prévoit que la capacité C est choisie beaucoup plus élevée que la capacité parasite, ou bien on tient compte dans le choix de la tension de référence Vprech-dV du fait que dV ne représentera plus qu'à un facteur multiplicatif près (lié au rapport entre la capacité C et la capacité parasite) la chute de tension acceptable sur Vpp. En effet, si Vpp descend de dV, le noeud flottant N ne descendra que d'une fraction de dV s'il est relié par une capacité parasite à la masse.

Le circuit de contrôle CTRL ne consomme que très peu de courant, notamment du fait qu'il ne comporte pas de diviseur résistif ou d'autre élément résistif connecté en permanence à Vpp.

La figure 5 représente un diagramme temporel des signaux dans le circuit de la figure 3. Dans ce diagramme, l'apparition du signal Sr correspond à une transition logique négative (de 1 vers 0) en sortie du comparateur CMP1; de même l'apparition du signal A qui commande le transistor T1; l'apparition du signal Sc correspond au contraire à une transition positive (de O vers 1) en sortie du comparateur CMP2. Ceci n'est bien entendu qu'un exemple.

## Revendications

1. Circuit de production d'une tension régulée Vpp, comprenant une pompe de charge (PMP) et un circuit de régulation (REG) pour interrompre la pompe de charge lorsque la tension Vpp dépasse une valeur prédéterminée, caractérisé en ce qu'il comporte en outre des moyens (T1) pour interrompre la consommation de courant du circuit de régulation lorsque la tension Vpp dépasse la valeur prédéterminée, et un circuit de contrôle (CTRL) mis en fonctionnement à partir de ce moment, ce circuit de contrôle étant apte à détecter une chute d'une valeur prédéterminée (dV) de la tension Vpp, et à fournir un signal (Sc) de remise en route de la pompe de charge et de la consommation de courant du circuit de régulation.

2. Circuit selon la revendication 1, caractérisé en ce que le circuit de contrôle (CTRL) comporte un noeud flottant (N) connecté par une capacité (C) à la tension Vpp, un moyen de précharge (T2) du noeud flottant à une valeur de tension prédéterminée Vprech, un comparateur (CMP2) ayant une entrée reliée au noeud flottant pour détecter le passage du potentiel du noeud flottant au dessous d'un niveau Vprech-dV prédéterminé, ce comparateur fournissant sur sa sortie le signal (Sc) de remise en route de la pompe de charge et de la consommation de courant du régulateur.

3. Circuit selon la revendication 2, caractérisé en ce que le circuit de contrôle (CTRL) comporte en outre un moyen (BS) commandé par le circuit de régulation (REG) pour fournir une impulsion courte à partir du moment où la tension Vpp dépasse la valeur prédéterminée, cette impulsion courte étant appliquée au moyen de précharge (T2) pour établir la précharge du noeud flottant.

4. Circuit selon l'une des revendication 1 à 3, caractérisé en ce que le circuit de régulation (REG) comporte un diviseur résistif (DR), un comparateur (CMP1) ayant une entrée reliée à un point intermédiaire du diviseur résistif, et un transistor (T1) pour interrompre l'alimentation en courant du diviseur résistif, le blocage de ce transistor étant commandé par un signal (Sr) issu du comparateur (CMP1), et sa mise en conduction étant commandée par un signal (Sc) issu du circuit de contrôle.

5. Circuit selon la revendication 4, caractérisé en ce que le diviseur résistif comporte des résistances en série constituées chacune par un transistor ayant sa grille reliée à son drain, chaque transistor étant réalisé dans un caisson individuel séparé des caissons des autres transistors.

6. Circuit intégré comportant une mémoire programmable électriquement, caractérisé en ce qu'il comporte un circuit selon l'une quelconque des revendications précédentes pour produire une tension de programmation Vpp pour la mémoire.

## Patentansprüche

1. Schaltung zur Erzeugung einer geregelten Spannung Vₚₚ, mit einem Spannungserhöher (PMP) und einem Regelschaltkreis (REG) zur Unterbrechung des Spannungserhöhers, wenn die Spannung Vₚₚ einen vorgegebenen Wert überschreitet, dadurch gekennzeichnet, daß sie außerdem eine Anordnung (T1) aufweist zur Unterbrechung des Stromverbrauchs des Regelschaltkreises, wenn die Spannung Vₚₚ einen vorgegebenen Wert überschreitet sowie den Steuerschaltkreis (CTRL) aufweist, der zu diesem Zeitpunkt wirksam wird, wobei der Steuerschaltkreis in der Lage ist, den Abfall eines vorgegebenen Wertes (dV) der Spannung Vₚₚ festzustellen und ein Signal (Sc) zu erzeugen zum Wiedereinschalten des Spannungserhöhers und des Stromverbrauchs des Regelschaltkreises.

2. Schaltung nach Anspruch 1, dadurch gekennzeichnet, daß der Steuerschaltkreis (CTRL) einen schwebenden Anschluß (N) aufweist, der über einen Kondensator (C) mit der Spannung Vₚₚ verbunden ist, eine Vorspannungsanordnung (T2) für den schwebenden Anschluß auf einen vorgegebenen Wert Vprech, einen Vergleicher (CMP2) aufweist, dessen einer Eingang mit dem schwebenden Anschluß verbunden ist, um den Übergang des Potentials des schwebenden Anschlusses unter den vorgegebenen Wert V_{prech-dV} zu messen, wobei dieser Vergleicher an seinem Ausgang das Signal (Sc) erzeugt zum Wiedereinschalten des Spannungserhöhers und des Stromverbrauchs des Regelschaltkreises.

3. Schaltung nach Anspruch 2, dadurch gekennzeichnet, daß der Steuerschaltkreis (CTRL) außerdem eine vom Regelschaltkreis (REG) gesteuerte Anordnung (BS) aufweist zur Erzeugung eines kurzen Impulses ab dem Moment, zu dem die Spannung Vₚₚ den vorgegebenen Wert überschreitet, wobei dieser kurze Impuls der Vorspannungsanordnung (T2) zugeführt wird, um den schwebenden Anschluß mit der Vorspannung zu beaufschlagen.

4. Schaltung nach einem der Ansprüche 1 bis 3, dadurch gekennzeichnet, daß der Regelschaltkreis (REG) einen Widerstandsteiler (DR) aufweist, einen Vergleicher (CMP1) aufweist, dessen einer Eingang mit einem Zwischenanschlußpunkt des Widerstandsteilers verbunden ist und einen Transistor (T1) aufweist, um die Stromversorgung des Widerstandsteilers zu unterbrechen, wobei die Unterbrechung dieses Transistors durch ein Signal (Sr) gesteuert wird, welches vom Vergleicher (CMP1) abgegeben wird und sein Einschalten in den leitenden Zustand durch ein Signal (Sc) gesteuert wird, welches vom Steuerschaltkreis abgegeben wird.

5. Schaltung nach Anspruch 4, dadurch gekennzeichnet, daß der Widerstandsteiler in Serie geschaltete Widerstände aufweist, deren jeder aus einem Transistor besteht, dessen Gitter mit seinem Drain verbunden ist, wobei jeder Transistor in einem individuellen von den Bereichen der anderen Transistoren getrennten Bereich ausgebildet ist.

6. Integrierte Schaltung mit einem elektrisch programmierbaren Speicher, dadurch gekennzeichnet, daß sie eine Schaltung nach einem der vorhergehenden Ansprüche aufweist, um eine Programmierspannung Vₚₚ für den Speicher zu erzeugen.

## Claims

1. Circuit for producing a controlled voltage Vpp, comprising a charging pump (PMP) and a regulating circuit (REG) serving to cut out the charging pump when the voltage Vpp exceeds a certain preselected value, characterised by the fact that it comprises, in addition, means (T1) for interrupting the consumption of current of the regulating circuit when the voltage Vpp exceeds the preselected value, and a control circuit (CTRL) set in operation as from that moment, this control circuit being capable of detecting a fall of the voltage Vpp from a preselected value (dV) and of supplying a signal (Sc) for reactivating the charging pump and the current consumption of the regulating circuit.

2. Circuit in accordance with claim 1, characterised by the fact that the control circuit (CTRL) comprises a floating knot (N) connected by a capacitor (C) to the voltage Vpp, a means for precharging (T2) the floating point to a preselected voltage value, Vprech, and a comparator (CMP2) having an input connected to the floating knot to detect the fall of the potential of the floating knot to below a preselected Vprech-dV level, this comparator supplying at its output the signal (Sc) for reactivating the charging pump and the current consumption of the regulator.

3. Circuit in accordance with claim 2, characterised by the fact that the control circuit (CTRL) also comprises a means (BS) controlled by the regulating circuit for the purpose of supplying a short pulse as from the moment when the voltage Vpp exceeds the preselected value, this short pulse being applied to the precharging means (T2) in order to establish the precharging of the floating knot.

4. Circuit in accordance with any one of claims 1 to 3, characterised by the fact that the regulating circuit (REG) comprises a resistant divider (DR), a comparator (CMP1) having an input connected to an intermediate point of the resistant divider, and a transistor (T1) serving to interrupt the current supply to the resistant divider, the blocking of this transistor being controlled by a signal (Sr) emitted from the comparator (CMP1) and the transistor being rendered conductive by a signal (Sc) emitted from the control circuit.

5. Circuit in accordance with claim 4, characterised by the fact that the resistant divider comprises resistances in series, each consisting of a transistor having its grid connected to its drain, each transistor being provided in an individual case separate from the cases of the other transistors.

6. Integrated circuit comprising an electrically programmable memory, characterised by the fact that it comprises a circuit in accordance with any one of the preceding claims, for the production of a programming voltage Vpp for the memory.
